# EUROPÄISCHE PATENTSCHRIFT

(11) **EP 0 683 435 B1**
(45) Veröffentlichungstag und Bekanntmachung des Hinweises auf die Patenterteilung: **04.06.1997**
(21) Anmeldenummer: 95105725.6
(22) Anmeldetag: 18.04.1995
(51) Int. Cl.: G03F 7/039

(54) **Positiv arbeitendes strahlungsempfindliches Gemisch**
Positive-working radiation-sensitive composition
Composition sensible aux radiations de type positif

(30) Priorität: 28.04.1994 DE 4414896
(43) Veröffentlichungstag der Anmeldung: 22.11.1995
(73) Patentinhaber: Agfa-Gevaert AG, 51373 Leverkusen (DE)
(72) Erfinder: Eichhorn, Mathias, Dr., D-65527 Niedernhausen (DE); Buhr, Gerhard, Dr., D-61462 Königstein (DE)

(56) Entgegenhaltungen:
- EP-A- 0 366 590

## Beschreibung

Die Erfindung betrifft ein positiv arbeitendes strahlungsempfindliches Gemisch mit a) einem polymeren Bindemittel mit säurelabilen Gruppen und b) einer bei Bestrahlung eine starke Säure bildenden Verbindung. Außerdem betrifft sie ein strahlungsempfindliches Aufzeichnungsmaterial mit einem Träger und einer aus diesem Gemisch hergestellten strahlungsempfindlichen Schicht zur Verwendung für Druckplatten und Photoresists.

Für solche Zwecke haben sich bisher vor allem die positiv arbeitenden Kopiermaterialien auf der Basis von o-Chinondiaziden durchgesetzt. Die Lichtempfindlichkeit dieser Materialien ist aber häufig unbefriedigend. Sie kann durch Verwendung katalytisch wirksamer Systeme gesteigert werden, da hierbei die Quantenausbeute größer als 1 wird. So wurde das bekannte Prinzip, durch photolytisch erzeugte Säuren Folgereaktionen auszulösen, um dadurch eine erhöhte Löslichkeit der belichteten Bereiche hervorzurufen, in neuerer Zeit genutzt. Dabei katalysieren photochemisch erzeugte starke Säuren die Spaltung säurelabiler Verbindungen, deren Spaltprodukte in wäßrig-alkalischen Entwicklern eine größere Löslichkeit als die Ursprungsverbindungen besitzen.

In positiv arbeitenden strahlungsempfindlichen Gemischen werden als säurespaltbare Verbindungen nieder- und hochmolekulare Acetale und O,N-Acetale, die als Hydroxy- oder Aminkomponente aromatische Verbindungen enthalten (US-A 3 779 778) verwendet, ebenso wie Orthoester und Amidacetale (US-A 4 101 323), polymere Orthoester (US-A 4 311 782), polymere aliphatische Acetale (US-A 4 247 611), Enolether (US-A 4 248 957) oder N-Acyliminocarbonate (US-A 4 250 247). Derartige Gemische benötigen zur Auslösung der Spaltreaktion neben der photochemisch erzeugten Säure auch Wasser, was zu Problemen in der praktischen Verwendbarkeit führt, insbesondere wenn bei verschiedener Luftfeuchtigkeit bestrahlt wird.

Polymere mit säurelabilen tert.-Butoxycarbonyloxy- oder tert.-Butoxycarbonyl("t-BOC")gruppen, die im Gemisch mit photochemischen Säurespendern positiv arbeiten, sind in den EP-A 0 102 450 und 0 366 590 beschrieben. Derartige Systeme benötigen zwar kein Wasser für die Auslösung der Spaltreaktion, sind aber ebenfalls nicht frei von Nachteilen. Die thermische Stabilität der damit hergestellten lichtempfindlichen Schichten ist unbefriedigend. Als Ursache dafür stellt H. Ito in J. Polym. Sci. A 24, 2971 (1986) die autokatalytische Spaltreaktion durch im Polymer enthaltene saure, phenolische Hydroxygruppen fest. Zur Lösung des Problems schlägt Ito die Synthese von Block-Copolymeren vor, in denen tBOC- und phenolische OH-Gruppen räumlich getrennt sind. Das ist allerdings ein präparativ aufwendiger Weg. In der EP-A 0 264 908 ist ein Polymer beschrieben, in dem die tert.-Butoxycarbonylgruppen durch weniger leicht spaltbare sec.-Butoxycarbonyl- oder Isopropoxycarbonylgruppen ersetzt sind, was aber Einbußen in der Lichtempfindlichkeit mit sich bringt.

Aufgabe der Erfindung war es, ein positiv arbeitendes strahlungsempfindliches Gemisch bereitzustellen, das sich durch hohe Lichtempfindlichkeit, sehr gute Lagerstabilität auch bei erhöhten Temperaturen und geringen Dunkelabtrag auszeichnet.

Gelöst wurde die Aufgabe durch ein Gemisch, das
a) ein polymeres Bindemittel mit säurelabilen Gruppen und
b) eine bei Bestrahlung eine starke Säure bildende Verbindung
enthält, dadurch gekennzeichnet, daß das Bindemittel a) gleichzeitig Einheiten der Formeln I, II und III

R¹-OH (I),

R¹-O-CO₂R² (II)

R¹-O-CH₂-CHR³-OH (III)

aufweist, worin
- R¹: einen in der Haupt- oder Seitenkette eines Polymers gebundenen, gegebenenfalls substituierten Phenylrest,
- R²: einen (C₃-C₁₁)Alkyl-, (C₃-C₁₁)Alkenyl- oder (C₇-C₁₁)Aralkylrest,
- R³: ein Wasserstoffatom, einen gegebenenfalls substituierten Alkyl- oder Arylrest, eine Phthalimidomethylgruppe oder die Gruppe -CH₂OR⁴, in der R⁴ ein Wasserstoffatom, ein aliphatischer, cycloaliphatischer oder aromatischer Rest ist, wobei diese Reste gegebenenfalls substituiert sein können,
bedeuten. Der Rest R² ist bevorzugt ein C₄-Alkyl, besonders bevorzugt tert.-Butyl. Ist der Rest R³ ein Alkyl, so handelt es sich bevorzugt um ein (C₁-C₄)Alkyl; ist er ein Aryl, so handelt es sich bevorzugt um Phenyl. Die Reste R³ und/oder R⁴ können innerhalb ein- und desselben Polymeren unterschiedlich sein.

Überraschenderweise sind die mit dem erfindungsgemäßen Gemisch hergestellten Schichten besonders lichtempfindlich und zeigen einen geringen Dunkelabtrag an den unbelichteten Stellen während des Entwickelns. Sie können selbst bei höherer Temperatur längere Zeit gelagert werden.

Die polymeren Bindemittel a) können hergestellt werden durch
- Umsetzen von Polymeren, die phenolische Hydroxygruppen enthalten, mit Epoxiden und aktivierten Kohlensäureestern in einem ein- oder mehrstufigen Verfahren oder
- Polymerisieren oder Polykondensieren von Monomeren, deren phenolische Hydroxygruppen mit Epoxiden umgesetzt sind, und Monomeren, deren phenolische Hydroxygruppen mit aktivierten Kohlensäureestern umgesetzt sind.

Die Polymere, die phenolische Hydroxygruppen enthalten, sind bevorzugt Polyhydroxystyrol, Poly(hydroxymethylstyrol) und Polybrenzkatechinmonomethacrylat. Allgemein sind Polymere und Copolymere geeignet, die Styrol, Hydroxystyrol, Hydroxymethylstyrol oder Hydroxyphenylmethacrylate, wie Brenzkatechinmonomethacrylat, als Monomereinheiten enthalten. Besonders bevorzugt sind Poly(4-hydroxystyrol), Poly(4-hydroxymethyl-styrol), Polybrenzkatechinmonomethacrylat, Copolymere aus Brenzkatechinmonomethacrylat und Styrol sowie Phenolharze, z. B. die bekannten Novolake. Die Polymere bzw. Copolymere können allein oder als Mischungen eingesetzt werden. Vorzugsweise sind in den erfindungsgemäßen Bindemitteln a) von der Gesamtzahl der Einheiten der Formeln I, II und III 10 bis 80 % Einheiten der Formeln II und III. Besonders bevorzugt sind solche Bindemittel a), in denen von der Gesamtzahl der Einheiten der Formeln I, II und III 25 bis 35 % Einheiten der Formel II und 10 bis 50 % Einheiten der Formel III sind.

Die Monomere mit phenolischen Hydroxygruppen sind bevorzugt Hydroxystyrole, Hydroxymethylstyrole, Hydroxyphenyl-acrylate und -methacrylate, z. B. Brenzkatechinmonomethacrylat.

Als Epoxide sind allgemein solche geeignet, die mit phenolischen Hydroxygruppen unter Ringöffnung reagieren. Besonders geeignet sind
- Epoxide von (C₁-C₁₂)Alkenen, wie Ethylenoxid (= Oxiran), Propenoxid (= Methyloxiran) und 1,2-Butenoxid (= Ethyloxiran);
- Glycidol (= 2,3-Epoxy-propan-1-ol = Oxiranylmethanol) und dessen Derivate, insbesondere dessen Alkyl- und Arylether, wie (2,3-Epoxy-propyl)-iso-propyl-ether, (2,3-Epoxy-propyl)-phenylether, (2,3-Epoxy-propyl)-(4-methoxy-phenyl)-ether,(2,3-Epoxy-propyl)-naphthalin-1-yl-ether oder N-(2,3-Epoxy-propyl)-phthalimid, und
- die Epoxide von ein- und mehrkernigen, gegebenenfalls substituierten Vinylaromaten, wie Styroloxid und Naphthalin-1-yl-oxiran.

Als aktivierte Kohlensäureester kommen alle Verbindungen, die -OR² als Alkoholkomponente enthalten, in Frage. Bevorzugt sind Chlorkohlensäurealkylester (z. B. Chlorkohlensäure-isopropylester,-sec.-butylester und -iso-pentylester) und Pyrokohlensäuredialkylester (z. B. Pyrokohlensäuredi-tert.-butylester = Di-tert.-butyldicarbonat).

Verfahren zur Umsetzung von Verbindungen, die phenolische Hydroxygruppen enthalten, mit Epoxiden oder aktivierten Kohlensäureestern sind dem Fachmann geläufig. Besonders vorteilhaft werden Polymere, die solche Gruppen enthalten, in einer "Ein-Topf"-Reaktion, ohne Isolierung einer Zwischenverbindung umgesetzt. Dazu löst man das Polymer in einem unter den Reaktionsbedingungen inerten Lösemittel, fügt einen Katalysator und anschließend das Epoxid (oder Gemisch von Epoxiden) sowie den aktivierten Kohlensäureester hinzu. Diese Reihenfolge kann auch geändert werden, indem man zuerst den aktivierten Kohlensäureester und dann das Epoxid zugibt. Gegebenenfalls wird das Reaktionsgemisch erwärmt. Es kann dabei vorteilhaft sein, zwischen der Zugabe der ersten und der zweiten Komponente eine gewisse Zeit zu warten. Der Katalysator kann heterogen oder homogen sein. Bevorzugte Katalysatoren sind saure oder basische Ionenaustauscher, Alkalihydroxide, Brönsted- und Lewis-Säuren sowie tertiäre Amine und quartäre Ammoniumsalze. Besonders bevorzugt sind quartäre Ammoniumhydroxide und Dialkylamino-pyridine. Davon sind Tetramethylammoniumhydroxid, Benzyltrimethylammoniumhydroxid (^{(R)}Triton B) und 4-Dimethylamino-pyridin (DMAP) besonders bevorzugt.

Geeignete inerte Lösemittel sind Ether (z. B. Diisopropylether und Tetrahydrofuran), Ketone (z. B. Aceton und Ethylmethylketon), chlorierte Kohlenwasserstoffe (z. B. Chloroform und Trichlorethylen) und Glykolether (z. B. Ethylenglykol-monomethylether). Bedingt geeignet sind auch Alkohole, vor allem schwach nucleophile, aliphatische Alkohole, wie Methanol und Ethanol. Besonders bevorzugt sind Propylenglykol-monomethylether, Tetrahydrofuran, Aceton und Methylethylketon. Prinzipiell kommen jedoch alle Lösemittel in Frage, die nicht irreversibel mit den übrigen Komponenten reagieren.

Nach beendeter Reaktion kann das Reaktionsprodukt mit bekannten Methoden, beispielsweise durch Fällen in Wasser oder durch Abziehen des Lösemittels bei gegebenenfalls vermindertem Druck, isoliert werden. Wird das Bindemittel a) durch Modifikation eines Polymers mit phenolischen Hydroxygruppen hergestellt, so kann das Reaktionsgemisch nach beendeter Reaktion, gegebenenfalls nach Abtrennung des heterogenen Katalysators oder Zusatz weiterer Komponenten, auch direkt zur Beschichtung eingesetzt werden.

Als strahlungsempfindliche Komponente b), die beim Bestrahlen starke Säure bildet, eignen sich viele bekannte Verbindungen. Hierzu zählen Diazonium-, Phosphonium-, Sulfonium- und Iodoniumsalze, Halogenverbindungen, sowie Organometall/ Organohalogen-Kombinationen.

Die genannten Diazonium-, Phosphonium-, Sulfonium- und Iodoniumverbindungen werden in der Regel in Form ihrer in organischen Lösemitteln löslichen Salze eingesetzt, beispielsweise in Form der Alkansulfonate, hoch- oder perfluorierte Alkansulfonate, Tetrafluorborate, Hexafluorphosphate, Hexafluorantimonate oder Hexafluorarsenate. Besonders bevorzugt sind Diazonium-perfluoralkansulfonate, sowie Diazonium-1,1,2,3,3,3-hexafluorpropansulfonate.

Die Azidität der beim Belichten von nicht weiter substituiertem 1,2-Naphthochinon-2-diazid entstehende Inden-2-carbonsäure reicht meist nur knapp für eine bildmäßige Differenzierung aus. Aus diesem Grund nimmt man als strahlungsempfindliche Verbindungen b) insbesondere ortho-Chinondiazidsulfonylchloride,-sulfonsäureester und -sulfonamide. Von diesen ist das 1,2-Naphthochinon-2-diazid-4-sulfonylchlorid besonders bevorzugt, da bei dessen Belichtung drei äquivalente Säuren (Carbonsäure, Sulfonsäure und HCl) frei werden und so ein relativ großer Verstärkungsfaktor erreicht wird.

Die Verbindungen b) können auch sogenannte "photochemische Radikalstarter" sein, die unter der Einwirkung aktinischer Strahlung Halogenwasserstoffsäure bilden. Verwendet werden meist solche mit mehr als einem Halogenatom. Ihre spektrale Empfindlichkeit kann durch die bekannten Sensibilisatoren beeinflußt werden. Beispiele für geeignete Starter zur Verwendung in dem erfindungsgemäßen strahlungsempfindlichen Gemisch sind: 1,2-Naphthochinon-2-diazid-4-sulfonylchlorid, 4-Dipropylaminobenzoldiazonium-tetrafluorborat,-hexafluorphosphat und -trifluormethansulfonat, 2,5-Diethoxy-4-p-tolylmercapto-benzoldiazoniumtetrafluorborat, -hexafluorphosphat,-trifluormethansulfonat und -1,1,2,3,3,3-hexafluorpropansulfonat, 4-Anilino-benzoldiazoniumsulfat, 4-Diethylamino-benzoldiazoniumtrifluormethansulfonat, 4-Methyl-6-trichlormethyl-2-pyron, 4-(3,4,5-Trimethoxy-styryl)-6-trichlormethyl-2-pyron, 4-(4-Methoxy-styryl)-6-(3,3,3-trichlorpropenyl)-2-pyron, 2-Trichlormethylbenzimidazol, 2-Tribrommethyl-chinolon, 2,4-Dimethyl-1-tribromacetyl-benzol, 3-Nitro-1-tribromacetylbenzol, 4-Dibromacetyl-benzoesäure, 1,4-Bisdibrommethylbenzol, verschiedene 4,6-Bis-trichlormethyl-s-triazine, wie 2-(6-Methoxy-naphthalin-2-yl)-, 2-(Naphthalin-1-yl)-, 2-(Naphthalin-2-yl)-, 2-[4-(2-Ethoxyethyl)-naphthalin-1-yl]-, 2-(Benzopyran-3-yl)-, 2-(Phenanthren-9-yl)-4,6-bis-trichlormethyl-, 2-(4-Styryl-phenyl)-4,6-bis-trichlormethyl-, 2-(4-Methoxyanthracen-1-yl)-4,6-bis-trichlormethyl-s-triazin, Trisdibrommethyl-s-triazin und die in den Beispielen angeführten Verbindungen.

Der Anteil des Starters kann je nach seiner chemischen Konstitution und der Zusammensetzung des Gemisches ebenfalls sehr unterschiedlich sein. Günstige Ergebnisse werden erhalten mit einem Anteil von etwa 0,1 bis 20 Gew.-%, bevorzugt 0,2 bis 10 Gew.-%, jeweils bezogen auf das Gesamtgewicht der nichtflüchtigen Bestandteile des Gemisches. Besonders für Kopierschichten von Dicken über 10 µm empfiehlt es sich, relativ wenig von der säurebildenden Komponente zu verwenden.

Das erfindungsgemäße Gemisch kann noch andere Polymere enthalten. Von diesen sind Vinylpolymere, wie Polyvinylacetat, Polyacrylat, Polyvinylether und Polyvinylpyrrolidon, die selbst durch Comonomere modifiziert sein können, bevorzugt. Der günstigste Anteil an diesen Polymeren richtet sich nach den anwendungstechnischen Erfordernissen und den Entwicklungsbedingungen. Er beträgt im allgemeinen nicht mehr als 20 Gew.-%, bezogen auf das Gesamtgewicht der polymeren Bindemittel a).

Je nach Anwendungszweck kann das erfindungsgemäße Gemisch schließlich noch untergeordnete Mengen an Polyglykolen, Cellulosederivaten, wie Ethylcellulose, Netzmitteln, UV-Absorbern, Farbstoffen und feinteiligen Pigmenten enthalten. Als Farbstoffe haben sich die Triphenylmethanfarbstoffe, insbesondere in Form ihrer Carbinolbasen, bewährt. Die günstigsten Mengenverhältnisse der Komponenten lassen sich im Einzelfall durch Vorversuche leicht ermitteln.

Gegenstand der vorliegenden Erfindung ist schließlich auch ein Aufzeichnungsmaterial mit einem Träger und einer strahlungsempfindlichen Schicht, das dadurch gekennzeichnet ist, daß die Schicht aus dem erfindungsgemäßen strahlungsempfindlichen Gemisch besteht.

Das Aufzeichnungsmaterial wird hergestellt, indem eine Lösung des erfindungsgemäßen Gemisches auf den Träger aufgebracht und das Lösemittel anschließend entfernt wird. Als Lösemittel geeignet sind Ketone (wie Methylethylketon), chlorierte Kohlenwasserstoffe (wie Trichlorethylen und 1,1,1-Trichlorethan), Alkohole (wie n-Propanol), Ether (wie Tetrahydrofuran), Alkoholether (wie Ethylenglykolmonoethylether) und Ester (wie Butylacetat). Es können auch Gemische davon verwendet werden. Als zusätzliches Lösemittel kann noch Acetonitril, Dioxan oder Dimethylformamid vorhanden sein. Allgemein sind alle Lösemittel verwendbar, die mit den Bestandteilen des erfindungsgemäßen Gemisches oder dem Trägermaterial nicht in unerwünschter Weise reagieren.

Lösemittel und Feststoffanteil in der Lösung richten sich auch nach dem Beschichtungs- und Trocknungsverfahren. Schichten bis etwa 5 µm Dicke werden im allgemeinen aufgeschleudert oder mit einem Streichrakel aufgetragen und anschließend getrocknet. Die dabei verwendeten Lösungen haben einen Feststoffanteil bis zu etwa 40 Gew.-%. Soll das Trägermaterial beidseitig beschichtet werden, so wird es in eine entsprechende Lösung eingetaucht. Niedrig siedende und damit leicht zu entfernende Lösemittel lassen die Schicht schnell antrocknen. Die Beschichtung kann auch durch Aufsprühen oder durch Antragen mit Hilfe von Walzen oder Breitschlitzdüsen erfolgen. Einzelplatten, insbesondere solche aus Zink oder Mehrmetall, werden vorteilhaft durch Gießantrag (curtain coating) beschichtet.

Im Vergleich zu anderen Positivschichten, besonders denen auf o-Naphthochinondiazidbasis, sind Belichtung und Verarbeitung von Schichtdicken bis ca. 100 µm und darüber möglich, da die Lichtempfindlichkeit der erfindungsgemäßen Gemische verhältnismäßig wenig dickenabhängig ist.

Schichten mit einer Dicke von mehr als 10 µm werden gewöhnlich erst auf einen Zwischenträger (normalerweise eine Kunststoffolie) aufgetragen und von dort auf den endgültigen Träger übertragen. Die Kunststoffolie ist häufig eine Polyester- (z. B. Polyethylenterephthalat) oder eine Polyolefinfolie (z. B. Polypropylen).

Zur Herstellung von Offsetdruckplatten haben die Aufzeichnungsmaterialien meist einen Träger aus mechanisch und/oder elektrochemisch aufgerauhtem und gegebenenfalls anodisiertem Aluminium, das noch chemisch, z. B. mit Polyvinylphosphonsäure, Silikaten oder Phosphaten, vorbehandelt sein kann. Geeignet sind auch Mehrmetallplatten mit einer Cu/Cr- oder Messing/Cr-Oberfläche. Die darauf aufgebrachten Aufzeichnungsschichten sind gewöhnlich dünner als 10 µm.

Zur Herstellung von Hochdruckplatten werden als Trägermaterialien Zink- oder Magnesiumträger sowie deren handelsübliche mikrokristalline Legierungen für Einstufenätzverfahren oder ätzbare Kunststoffe wie Polyoxymethylen verwendet.

Für Tiefdruck- oder Siebdruckformen eignen sich Träger mit Kupfer- oder Nickeloberflächen, auf denen das erfindungsgemäße Gemisch besonders gut haftet. Diese Schichten zeichnen sich auch hier durch die gute Ätzfestigkeit aus.

Weiterhin lassen sich die erfindungsgemäßen Gemische als Photoresists und beim Formteilätzen verwenden. Ebenso eignen sie sich zur Beschichtung von
- Leiterplatten aus einem elektrisch nicht-leitenden Material, die ein- oder beidseitig mit einer Kupferauflage versehen sind,
- gegebenenfalls haftvermittelnd vorbehandelten Glas- oder Keramikmaterialien,
- Siliciumscheiben, auf deren Oberfläche sich gegebenenfalls eine Nitrid- oder Oxidschicht befindet; die Beschichtung kann direkt oder mit Hilfe eines Zwischenträgers erfolgen;
- Holz,
- Textilien und den
- Oberflächen vieler Werkstoffe, die durch Projektion bebildert werden und resistent gegen die Einwirkung alkalischer Entwickler sind.

Für die Trocknung der Schicht können die üblichen Geräte und Bedingungen übernommen werden, Temperaturen um 100 °C und kurzfristig bis 120 °C werden ohne Einbuße an Strahlungsempfindlichkeit vertragen.

Zum Belichten können die üblichen Kopiergeräte wie Röhrenlampen, Xenonimpulslampen, metallhalogeniddotierte Quecksilberdampf-Hochdrucklampen und Kohlebogenlampen verwendet werden. Darüber hinaus ist das Belichten in üblichen Projektions- und Vergrößerungsgeräten unter dem Licht der Metallfadenlampen und Kontaktbelichtung mit gewöhnlichen Glühbirnen möglich. Die Belichtung kann auch mit dem kohärenten Licht eines Lasers erfolgen. Geeignet sind leistungsgerechte kurzwellige Laser, beispielsweise Argon-Ionen-Laser, Krypton-Ionen-Laser, Farbstoff-Laser und Helium-Cadmium-Laser, die zwischen 300 und 600 nm emittieren. Der Laserstrahl wird mit einer vorgegebenen programmierten Strich- und/oder Rasterbewegung gesteuert.

Das Bestrahlen mit Elektronenstrahlen ist eine weitere Bebilderungsmöglichkeit. Elektronenstrahlen können das erfindungsgemäße Gemisch, wie auch viele andere organische Materialien, durchgreifend zersetzen und vernetzen, so daß ein negatives Bild entsteht, wenn die unbestrahlten Teile durch Lösemittel oder Belichten ohne Vorlage und Entwickeln entfernt werden. Bei geringerer Intensität und/oder höherer Schreibgeschwindigkeit des Elektronenstrahls bewirkt dagegen der Elektronenstrahl eine Differenzierung in Richtung höherer Löslichkeit, d.h. die bestrahlten Schichtpartien können vom Entwickler entfernt werden. Die Wahl der günstigsten Bedingungen kann durch Vorversuche leicht ermittelt werden.

Die bildmäßig belichtete oder bestrahlte Schicht kann - gegebenenfalls nach einem thermischen Nachbehandlungsschritt zur Vervollständigung der durch die photolytisch freigesetzte Säure eingeleiteten Reaktion - mit praktisch den gleichen Entwicklern wie für handelsübliche Naphthochinondiazidschichten und Kopierlacke entfernt werden. Die neuen Schichten können in ihren Kopierbedingungen vorteilhaft auf die bekannten Hilfsmittel, wie Entwickler und programmierte Sprühentwicklungsgeräte, abgestimmt werden. Die wäßrigen Entwicklerlösungen können z. B. Alkaliphosphate, -silikate oder -hydroxide und ferner Netzmittel sowie kleinere Anteile organischer Lösemittel enthalten. In bestimmten Fällen sind auch Lösemittel/Wasser-Gemische als Entwickler brauchbar. Der günstigste Entwickler kann durch Versuche mit der jeweils verwendeten Schicht ermittelt werden. Bei Bedarf kann die Entwicklung mechanisch unterstützt werden. Zur Erhöhung der Widerstandsfähigkeit beim Druck sowie der Resistenz gegen Auswaschmittel, Korrekturmittel und durch UV-Licht härtbare Druckfarben können die entwickelten Platten kurze Zeit auf erhöhte Temperaturen erwärmt werden, wie es für Diazoschichten aus der GB-A 1 154 749 bekannt ist.

Schließlich betrifft die Erfindung auch noch ein Verfahren zur Herstellung von Reliefbildern, bei dem man ein strahlungsempfindliches Aufzeichnungsmaterial bildmäßig mit aktinischer Strahlung bestrahlt, gegebenenfalls nacherwärmt und danach die bestrahlten Schichtteile mit einem flüssigen Entwickler auswäscht.

Die nachfolgenden Beispiele zeigen die Synthese der für den Aufbau der erfindungsgemäßen, lichtempfindlichen Schichten einsetzbaren Bindemittel sowie die bevorzugten erfindungsgemäßen Gemische selbst, ohne die Erfindung auf diese zu beschränken.

### Beispiel 1

7,5 g eines Polymers (Hydroxylzahl 267), erhalten durch Umsetzung von 1 Moläquiv. Poly(4-hydroxy-styrol) (MW 4500 g/mol, Hydroxylzahl 455) mit 0,3 Moläquiv. Di-tert.-butyldicarbonat, wurden in 50 ml Methylethylketon gelöst, 0,1 g Tetramethylammoniumhydroxid sowie 3,3 ml 2,3-Epoxy-propanol hinzugefügt und 3 h unter Rückfluß erhitzt. Nach dem Ausfällen in Wasser, Absaugen und Trocknen erhielt man 7,4 g eines alkalilöslichen Polymers mit der Hydroxylzahl 359. Mit ¹H-NMR wurde das Verhältnis der freien phenolischen OH-Gruppen zu den tBOC- und aliphatischen OH-Gruppen mit 35:25:40 bestimmt.

### Beispiel 2

7,5 g eines partiell mit Di-tert.-butyldicarbonat acylierten Poly(4-hydroxy-styrols) (Hydroxylzahl 267; siehe Beispiel 1) wurden in 50 ml Methylethylketon gelöst, 0,1 g Tetramethylammoniumhydroxyd sowie 1 ml (2,3-Epoxy-propyl)-isopropylether hinzugefügt und 2 h unter Rückfluß erhitzt. Nach dem Ausfällen in Wasser, Absaugen und Trocknen erhielt man 7,4 g eines alkalilöslichen Harzes. Mit ¹H-NMR wurde das Verhältnis der freien phenolischen OH-Gruppen zu den tBOC- und aliphatischen OH-Gruppen zu 65:25:10 bestimmt.

### Beispiel 3

Es wurde wie in Beispiel 2 verfahren, jedoch (2,3-Epoxy-propyl)-o-tolyl-ether anstatt (2,3-Epoxy-propyl)-isopropyl-ether eingesetzt. Das erhaltene Polymer wies ein Verhältnis der freien phenolischen OH-Gruppen zu den tBOC- und aliphatischen OH-Gruppen von 65:25:10 auf (bestimmt durch ¹H-NMR).

### Beispiel 4

Zu einer Lösung aus 192 g Poly(4-hydroxy-styrol) (MW 4500 g/mol, Hydroxylzahl 455) in 750 ml Propylenglykolmonomethylether (^{(R)}Dowanol PM) wurden 2 ml einer 40%igen Lösung von Benzyltrimethylammoniumhydroxid (^{(R)}Triton B) in Methanol und 16 ml 2,3-Epoxy-propanol hinzugefügt. Das Gemisch wurde 7 h unter Rückfluß erhitzt. Nach dem Abkühlen auf Raumtemperatur wurden dann 0,5 g 4-Dimethylamino-pyridin zugegeben. Anschließend wurde unter Rühren mit einem Magnetrührer eine Lösung von 105 g Di-tert.-butyldicarbonat in 100 ml Propylenglykol-monomethylether zugetropft, 4 h bei Raumtemperatur weitergerührt, in Wasser gefällt, abgesaugt und getrocknet (40 °C/50 mbar). Mit Hilfe der ¹H-NMR bestimmte man das Verhältnis der freien phenolischen OH-Gruppen zu den tBOC- und aliphatischen OH-Gruppen zu 55:30:15 in dem erhaltenen Polymer (253 g; Hydroxylzahl: 296).

### Beispiel 5

Platten aus elektrochemisch aufgerauhtem und anodisiertem Aluminium wurden mit einer Lösung aus
- 3,60 Gt: des in Beispiel 4 beschriebenen Bindemittels (hergestellt aus Poly(4-hydroxy-styrol), 2,3-Epoxypropanol und Di-tert.-butyldicarbonat),
- 0,20 Gt: 4-p-Tolylmercapto-2,5-diethoxy-benzoldiazoniumhexafluorphosphat,
- 0,03 Gt: Kristallviolettbase und
- 35 Gt: Methylethylketon
schleuderbeschichtet und bei 100 °C im Trockenschrank erhitzt. Nach dem Trocknen betrug die Schichtdicke 1,8 bis 2,0 µm. Die Platten wurde unter einer 5kW-Metallhalogenidlampe im Abstand von 110 cm durch eine Bildvorlage 20 s lang belichtet, 1 min bei 100 °C nacherwärmt und in einem wäßrig-alkalischen Entwickler der Zusammensetzung
- 5,5 Gt: Natriummetasilikat · 9 H₂O,
- 3,4 Gt: Trinatriumphosphat · 12 H₂O,
- 0,4 Gt: Mononatriumphosphat wasserfrei und
- 90,7 Gt: vollentsalztes Wasser
30 s lang entwickelt. Man erhielt ein positives Abbild der Filmvorlage, das in einer Offsetdruckmaschine mehr als 100 000 Drucke in guter Qualität lieferte.

### Beispiel 6

Platten aus elektrochemisch aufgerauhtem und anodisiertem Aluminium wurden mit einer Lösung aus
- 3,60 Gt: Bindemittel 1 (Herstellung s. Beispiel 4) bzw. als Vergleich Bindemittel 2 [Poly(4-hydroxy-styrol)], hydroxy-styrol)], umgesetzt mit 0,3 eq Di-tert.-butyldicarbonat),
- 0,20 Gt: 4-p-Tolylmercapto-2,5-diethoxy-benzoldiazonium-1,1,2,3,3,3-hexafluorpropansulfonat,
- 0,03 Gt: Kristallviolettbase und
- 35 Gt: Methylethylketon
schleuderbeschichtet und bei 100 °C im Trockenschrank erhitzt. Nach dem Trocknen betrug die Schichtdicke 1,9 µm. Die Platten wurden einem forcierten Lagertest bei 80 °C unterworfen. Zu unterschiedlichen Zeiten wurden Proben entnommen, unter einer 5-kW-Metallhalogenidlampe im Abstand von 110 cm durch einen Halbtonstufenkeil mit 13 Stufen einer Dichteabstufung von 0,15 20 s lang belichtet, 1 min bei 100 °C nacherwärmt und in einem wäßrig-alkalischen Entwickler (siehe Beispiel 5) 30 s lang entwickelt. Die Beurteilung der Lagerstabilität erfolgte anhand der auf der Platte voll offen bzw. voll geschlossen wiedergegebenen Halbtonkeilstufen, wobei sich ein mit der Lagerdauer zunehmend größerer Dunkelabtrag (Löslichkeit der Kopierschicht in den unbelichteten Bereichen) zeigte. Die folgende Tabelle beweist die ausgezeichnete Lagerstabilität der erfindungsgemäßen lichtempfindlichen Gemische bei unveränderten kopier- und drucktechnischen Eigenschaften (Bindemittel 2 zum Vergleich).

**Tabelle**

| Zeit bei 80 °C | offene Stufe | | gedeckte Stufe | |
|---|---|---|---|---|
| | Bindemittel 1 | Bindemittel 2 | Bindemittel 1 | Bindemittel 2 |
| 0 h | 3 | 3 | 8-9 | 9 |
| 1 h | 3 | 4-5 | 9 | 10-11 |
| 2 h | 3-4 | 6 | 10 | 13 |
| 3 h | 4 | 13 | 10-11 | - |
| 4 h | 4-5 | 13 | 11 | - |

## Patentansprüche

1. Positiv arbeitendes, strahlungsempfindliches Gemisch, das
a) ein polymeres Bindemittel mit säurelabilen Gruppen und
b) eine bei Bestrahlung eine starke Säure bildende Verbindung
enthält, dadurch gekennzeichnet, daß das Bindemittel a) gleichzeitig Einheiten der Formeln I, II und III
R¹-OH (I),
R¹-O-CO₂R² (II)
R¹-O-CH₂-CHR³-OH (III)
aufweist, worin
R¹ einen in der Haupt- oder Seitenkette eines Polymers gebundenen, gegebenenfalls substituierten Phenylrest,
R² einen (C₃-C₁₁)Alkyl-, (C₃-C₁₁)Alkenyl- oder (C₇-C₁₁)Aralkylrest,
R³ ein Wasserstoffatom, einen gegebenenfalls substituierten Alkyl- oder Arylrest, eine Phthalimidomethylgruppe oder die Gruppe -CH₂OR⁴, in der R⁴ ein Wasserstoffatom, ein aliphatischer, cycloaliphatischer oder aromatischer Rest ist, wobei diese Reste gegebenenfalls substituiert sein können,
bedeuten.

2. Strahlungsempfindliches Gemisch gemäß Anspruch 1, dadurch gekennzeichet, daß der Rest R² ein C₄-Alkyl, bevorzugt tert.-Butyl, ist.

3. Strahlungsempfindliches Gemisch gemäß Anspruch 1 oder 2, dadurch gekennzeichnet, daß in dem Bindemittel a) von der Gesamtzahl der Einheiten der Formeln I, II und III 10 bis 80 % Einheiten der Formeln II und III sind.

4. Strahlungsempfindliches Gemisch gemäß einem oder mehreren der Ansprüche 1 bis 3, dadurch gekennzeichnet, daß das dem Bindemittel a) zugrundeliegende Polymer Polyhydroxystyrol, Polyhydroxymethylstyrol, Poly(brenzkatechinmonomethacrylat) oder ein Copolymer mit Einheiten aus Hydroxystyrol, Hydroxymethylstyrol oder Brenzkatechinmonomethacrylat ist, wobei Poly(4-hydroxy-styrol), Poly(4-hydroxymethylstyrol) und Poly(brenzkatechin-monomethacrylat) bevorzugt sind.

5. Strahlungsempfindliches Gemisch gemäß einem oder mehreren der Ansprüche 1 bis 4, dadurch gekennzeichnet, daß die bei Bestrahlung Säure bildende Verbindung b) ein Diazonium-, Sulfonium- oder Iodoniumsalz ist, wobei Diazoniumperfluoralkansulfonate, insbesondere Diazonium-1,1,2,3,3,3-hexafluorpropansulfonate, bevorzugt sind.

6. Strahlungsempfindliches Gemisch gemäß einem oder mehreren der Ansprüche 1 bis 5, dadurch gekennzeichnet, daß der Anteil des Starters 0,1 bis 20 Gew.-%, bevorzugt 0,2 bis 10 Gew.-%, jeweils bezogen auf das Gesamtgewicht der nichtflüchtigen Bestandteile des Gemisches, beträgt.

7. Aufzeichnungsmaterial mit einem Träger und einer strahlungsempfindlichen Schicht, dadurch gekennzeichnet, daß die Schicht aus einem strahlungsempfindlichen Gemisch gemäß einem oder mehreren der Ansprüche 1 bis 6 besteht.

## Claims

1. A positive, photosensitive mixture, containing
a) a polymeric binder containing acid-labile groups and
b) a compound, which on irradiation forms a strong acid,
characterised in that the binder a) contains simultaneously units corresponding to formulae I, II, and III
R¹-OH (I)
R¹-O-CO₂R² (II)
R¹-O-CH₂-CHR³-OH (III)
wherein
R¹ denotes an optionally substituted phenyl group, bonded to the main chain or side chain of a polymer,
R² denotes a (C₃-C₁₁) alkyl, (C₃-C₁₁) alkenyl or (C₇-C₁₁) aralkyl group,
R³ denotes a hydrogen atom, an optionally substituted alkyl or aryl group, a phthalimidomethyl group or the group -CH₂OR⁴, wherein R⁴ is a hydrogen atom, an aliphatic, cycloaliphatic or aromatic group, these groups optionally being substitutable.

2. A photosensitive mixture according to claim 1, characterised in that the group R² is a C₄ alkyl group, preferably tert. butyl.

3. A photosensitive mixture according to claim 1 or 2, characterised in that in the binder a), of the total number of units corresponding to formulae I, II and III, from 10% to 80% of the units correspond to formulae II and III.

4. A photosensitive mixture according to one or more of claims 1 to 3, characterised in that the polymer forming the basis of the binder a) is polyhydroxystyrene, polyhydroxymethylstyrene, poly(catechol monomethacrylate) or a copolymer containing units of hydroxystyrene, hydroxymethylstyrene or catechol monomethacrylate, with poly(4-hydroxystyrene), poly(4-hydroxymethylstyrene) and poly(catechol monomethacrylate) being preferred.

5. A photosensitive mixture according to one or more of claims 1 to 4, characterised in that the compound b), which on irradiation forms an acid, is a diazonium, sulphonium or iodonium salt, with diazonium perfluoroalkanesulphonates, in particular diazonium 1,1,2,3,3,3-hexafluoropropanesulphonate, being preferred.

6. A photosensitive mixture according to one or more of claims 1 to 5, characterised in that the proportion of the starter is from 0.1 to 20 wt.%, preferably from 0.2 to 10 wt.%, each referred to the total weight of the non-volatile constituents of the mixture.

7. Recording material having a support and a photosensitive layer, characterised in that the layer consists of a photosensitive mixture according to one or more of claims 1 to 6.

## Revendications

1. Mélange photosensible positif qui contient :
a) un liant polymère avec des groupes éliminables par des acides et
b) un liant formant un acide fort lors de l'insolation.
caractérisé en ce que le liant contient a) simultanément des motifs de formules I, II et III
R¹-OH (I),
R¹-O-CO₂R² (II),
R¹-O-CH₂-CHR³-OH (III)
où
R¹ représente un reste phényle substitué le cas échéant, lié dans la chaîne principale ou une chaîne latérale d'un polymère,
R² est un reste alkyle (C₃-C₁₁), alcényle (C₃-C₁₁) ou un reste aralkyle (C₇-C₁₁),
R³ est un atome d'hydrogène, un reste alkyle ou aryle substitué le cas échéant, un groupe phtalimidométhyle ou le groupe -CH₂OR⁴, où R⁴ est un atome d'hydrogène, un reste aliphatique, cycloaliphatique ou aromatique, où les restes peuvent être substitués, le cas échéant.

2. Mélange photosensible selon la revendication 1, caractérisé en ce que le reste R² est un alkyle en C₄, de préférence du tert-butyle.

3. Mélange photosensible selon la revendication 1 ou 2, caractérisé en ce que dans le liant a) dans le nombre total des motifs de formules I, II et III 10 à 80% des motifs sont ceux de formules II et III.

4. Mélange photosensible selon une ou plusieurs des revendications 1 à 3, caractérisé en ce que le polymère à la base du liant a) est du polyhydroxystyrène, du polyhydroxyméthylstyrène, du poly(monométhacrylate de pyrocatéchol) ou un copolymère avec des motifs d'hydroxystyrène, d'hydroxyméthylstyrène ou de monométhacrylate de pyrocatéchol, où on préfère les poly(4-hydroxy-styrènes), poly(4-hydroxyméthylstyrènes) et poly(monométhacrylate de pyrocatéchol).

5. Mélange photosensible selon l'une ou plusieurs des revendications 1 à 4, caractérisé en ce que le composé b) formant un acide lors de l'insolation est un sel de diazonium, de sulfonium ou d'iononium où on préfère les perfluoroalcanesulfonate de diazonium, notamment le 1,1,2,3,3,3-hexafluoropropanesulfonate de diazonium.

6. Mélange photosensible selon l'une ou plusieurs des revendications 1 à 5, caractérisé en ce que la teneur de l'initiateur représente 0,1 à 20% en poids, de préférence 0,2 à 10% en poids, rapporté respectivement au poids total des composants non volatils du mélange.

7. Matériel d'enregistrement avec un support et une couche photosensible, caractérisé en ce que la couche est constituée d'un mélange photosensible selon l'une ou plusieurs des revendications 1 à 6.
